# EUROPEAN PATENT APPLICATION

(11) **EP 2 028 501 A1**
(43) Date of publication of application: **25.02.2009**
(21) Application number: 06822072.2
(22) Date of filing: 23.10.2006
(51) Int. Cl.: G01R 31/311, G01N 21/956

(54) **SEMICONDUCTOR DEFECT ANALYSIS DEVICE, DEFECT ANALYSIS METHOD, AND DEFECT ANALYSIS PROGRAM**

(30) Priority: 14.06.2006 JP 2006165179
(71) Applicant: Hamamatsu Photonics K.K., Hamamatsu-shi Shizuoka 435-8558 (JP)
(72) Inventor: MAJIMA, Toshiyuki, Kodaira-shi Tokyo 187-8588 (JP); SHIMASE, Akira, Kodaira-shi Tokyo 187-8588 (JP); TERADA, Hirotoshi, Hamamatsu-shi Shizuoka 435-8558 (JP); HOTTA, Kazuhiro, Hamamatsu-shi Shizuoka 435-8558 (JP)
(74) Representative: Frost, Alex John
(86) International application number: PCT/JP2006/321061
(87) International publication number: WO 2007/144969

(57) **Abstract**

A failure analysis apparatus 10 is composed of an inspection information acquirer 11 for acquiring a failure observed image P2 of a semiconductor device, a layout information acquirer 12 for acquiring layout information, and a failure analyzer 13 for analyzing a failure of the semiconductor device. The failure analyzer 13 has an analysis region setter for comparing an intensity distribution in the failure observed image with a predetermined intensity threshold to extract a reaction region arising from a failure, and for setting an analysis region used in the failure analysis of the semiconductor device, in correspondence to the reaction region. This substantializes a semiconductor failure analysis apparatus, failure analysis method, and failure analysis program capable of securely and efficiently performing the analysis of the failure of the semiconductor device using the failure observed image.

## Description

### Technical Field

The present invention relates to a semiconductor failure analysis apparatus, failure analysis method, and failure analysis program for analyzing a failure of a semiconductor device.

### Background Art

The conventionally available semiconductor inspection apparatus for acquiring an observed image for analysis of failure of a semiconductor device include emission microscopes, OBIRCH apparatus, time-resolved emission microscopes, and so on. These inspection apparatus are able to analyze such a failure as a broken part in a semiconductor device by use of an emission image or OBIRCH image acquired as a failure observed image (e.g., reference is made to Patent Documents 1, 2).
Patent Document 1: Japanese Patent Application Laid-Open No. 2003-86689
Patent Document 2: Japanese Patent Application Laid-Open No. 2003-303746

### Disclosure of the Invention

### Problems to be Solved by the Invention

In recent years, semiconductor devices as analysis objects in the semiconductor failure analysis have been miniaturized and integrated more and more, and it has become difficult to perform the analysis of failure part by means of the aforementioned inspection apparatus. In order to analyze the failure part of such a semiconductor device, it is thus essential to improve certainty and efficiency of the analysis process for estimating the failure part of the semiconductor device from the failure observed image.

The present invention has been accomplished in order to solve the above problem, and an object of the invention is to provide a semiconductor failure analysis apparatus, failure analysis method, and failure analysis program capable of securely and efficiently performing an analysis of a failure of a semiconductor device with use of a failure observed image.

### Means for Solving the Problem

In order to achieve the above object, a semiconductor failure analysis apparatus according to the present invention is a semiconductor failure analysis apparatus for analyzing a failure of a semiconductor device, comprising: (1) inspection information acquiring means for acquiring a failure observed image containing reaction information arising from a failure, acquired by conducting an inspection about the failure, as an observed image of the semiconductor device; and (2) failure analyzing means for analyzing the failure of the semiconductor device with reference to the failure observed image and layout information of the semiconductor device; (3) wherein the failure analyzing means has analysis region setting means for comparing an intensity distribution in the failure observed image with a predetermined intensity threshold to extract a reaction region as the reaction information, and for setting an analysis region used in the analysis of the failure of the semiconductor device, in correspondence to the reaction region.

A semiconductor failure analysis method according to the present invention is a semiconductor failure analysis method of analyzing a failure of a semiconductor device, comprising: (1) an inspection information acquiring step of acquiring a failure observed image containing reaction information arising from a failure, acquired by conducting an inspection about the failure, as an observed image of the semiconductor device; and (2) a failure analyzing step of analyzing the failure of the semiconductor device with reference to the failure observed image and layout information of the semiconductor device; (3) wherein the failure analyzing step comprises an analysis region setting step of comparing an intensity distribution in the failure observed image with a predetermined intensity threshold to extract a reaction region as the reaction information, and setting an analysis region used in the analysis of the failure of the semiconductor device, in correspondence to the reaction region.

A semiconductor failure analysis program according to the present invention is a program for letting a computer execute a semiconductor failure analysis of analyzing a failure of a semiconductor device, the program letting the computer execute: (1) an inspection information acquiring process of acquiring a failure observed image containing reaction information arising from a failure, acquired by conducting an inspection about the failure, as an observed image of the semiconductor device; and (2) a failure analyzing process of analyzing the failure of the semiconductor device with reference to the failure observed image and layout information of the semiconductor device; (3) wherein the failure analyzing process comprises an analysis region setting process of comparing an intensity distribution in the failure observed image with a predetermined intensity threshold to extract a reaction region as the reaction information, and setting an analysis region used in the analysis of the failure of the semiconductor device, in correspondence to the reaction region.

The semiconductor failure analysis apparatus, failure analysis method, and failure analysis program described above are arranged to acquire the failure observed image such as an emission image or OBIRCH image obtained by inspecting the semiconductor device as an analysis object. Then an analysis region is set in correspondence to the reaction information (e.g., information about a reaction part) in the failure observation image, and the analysis of the failure of the semiconductor device is performed with reference to the necessary information about the layout of the semiconductor device. This configuration permits us to suitably execute the failure analysis of the semiconductor device using the failure observed image, with reference to the analysis region.

Furthermore, the above configuration is arranged as follows as to the setting of the analysis region based on the failure observed image; the intensity threshold is applied to the intensity distribution in the failure observed image consisting of a plurality of pixels, to extract the reaction region corresponding to the reaction part or the like in the semiconductor device, and the analysis region is set based on the reaction region thus extracted. This makes it feasible to suitably set the analysis region used in the failure analysis and to securely and efficiently perform the analysis of the failure of the semiconductor device. This configuration of applying the intensity threshold can also be arranged to automatically perform the setting of the analysis region in the failure observed image, and thereby further improve the efficiency of the failure analysis.

### Effects of the Invention

Since the semiconductor failure analysis apparatus, failure analysis method, and failure analysis program of the present invention are arranged to apply the intensity threshold to the intensity distribution in the failure observed image to extract the reaction region, to set the analysis region on the basis of this extracted reaction region, and to perform the failure analysis of the semiconductor device, it becomes feasible to suitably set the analysis region used in the failure analysis and to securely and efficiently perform the failure analysis of the semiconductor device.

### Brief Description of the Drawings

[Fig. 1] Fig. 1 is a block diagram showing a configuration of an embodiment of a failure analysis system incorporating the semiconductor failure analysis apparatus.
[Fig. 2] Fig. 2 is a block diagram showing a specific configuration of a failure analyzer.
[Fig. 3] Fig. 3 is a drawing schematically showing a semiconductor failure analysis method.
[Fig. 4] Fig. 4 is a drawing schematically showing extraction of reaction regions and setting of analysis regions.
[Fig. 5] Fig. 5 is a drawing schematically showing setting of an analysis region.
[Fig. 6] Fig. 6 is a configuration diagram showing an example of a setting window displayed on a display device.
[Fig. 7] Fig. 7 is a configuration diagram showing an example of semiconductor inspection apparatus.
[Fig. 8] Fig. 8 is a configuration diagram as a side view of the semiconductor inspection apparatus shown in Fig. 7.
[Fig. 9] Fig. 9 is a drawing schematically showing a masking process for a failure observed image.
[Fig. 10] Fig. 10 is a drawing schematically showing a masking process for a failure observed image.
[Fig. 11] Fig. 11 is a drawing schematically showing a masking process for a failure observed image.
[Fig. 12] Fig. 12 is a drawing schematically showing an example of an analysis process using a failure observed image.
[Fig. 13] Fig. 13 is a drawing schematically showing an example of an analysis process using a failure observed image.
[Fig. 14] Fig. 14 is a drawing showing selection of a layer as an analysis object in an OBIRCH image.
[Fig. 15] Fig. 15 is a drawing schematically showing a correspondence among observed images and a layout image.
[Fig. 16] Fig. 16 is a configuration diagram showing an example of a display window displayed on a display device.

### Description of Symbols

1 - semiconductor failure analysis system, 10 - semiconductor failure analysis apparatus, 11 - inspection information acquirer, 12 - layout information acquirer, 13 - failure analyzer, 131 - region setter, 136 - analysis region setter, 137 - mask region setter, 132 - net information analyzer, 133 - position adjuster, 134 - additional analysis information acquirer, 135 - analysis object selector, 14 - analysis screen display controller, 15 - layout image display controller, 20 - inspection information supplying apparatus, 20A - semiconductor inspection apparatus, 21 - observation section, 22 - control section, 23 - inspection information processor, 24 - display device, 30 - layout information supplying apparatus, 40 - display device, 45 - input device,
P1 - pattern image, P2 - failure observed image, P3 - layout image, P6 - superimposed image, A, A1 - A6 - emission region, B, B1 - B6 - analysis region, C, C1 - C4 - net, D1, D2 - standard reaction region, E1, E2 - mask region.

### Best Modes for Carrying Out the Invention

Preferred embodiments of the semiconductor failure analysis apparatus, failure analysis method, and failure analysis program according to the present invention will be described below in detail with reference to the drawings. In the description of the drawings the same elements will be denoted by the same reference symbols, without redundant description. It is also noted that dimensional ratios in the drawings do not always agree with those in the description.

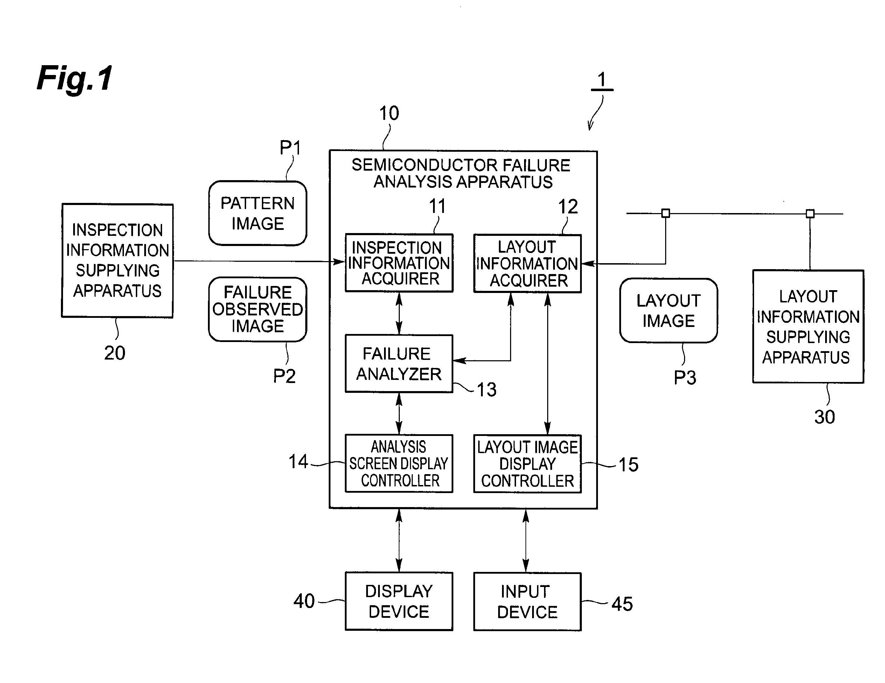

Fig. 1 is a block diagram schematically showing a configuration of an embodiment of the failure analysis system incorporating the semiconductor failure analysis apparatus according to the present invention. The present failure analysis system 1 is a system an analysis object of which is a semiconductor device and which is for carrying out an analysis of a failure with the use of an observed image thereof, and the system comprises a semiconductor failure analysis apparatus 10, an inspection information supplying apparatus 20, a layout information supplying apparatus 30, a display device 40, and an input device 45. Configurations of the semiconductor failure analysis apparatus 10 and failure analysis system 1 will be described below along with a semiconductor failure analysis method.

The semiconductor failure analysis apparatus 10 is an analyzer for importing data necessary for the analysis of the failure of the semiconductor device and executing the analysis processing of the failure. The failure analysis apparatus 10 according to the present embodiment has an inspection information acquirer 11, a layout information acquirer 12, a failure analyzer 13, an analysis screen display controller 14, and a layout image display controller 15. Devices connected to the failure analysis apparatus 10 include the display device 40 for displaying information about the failure analysis, and the input device 45 used for input of instructions and information necessary for the failure analysis.

Data to be used in the failure analysis executed in the failure analysis apparatus 10 is acquired by the inspection information acquirer 11 and by the layout information acquirer 12. The inspection information acquirer 11 acquires a pattern image P1 being a normal observed image, and a failure observed image P2 containing reaction information arising from a failure, obtained by conducting an inspection about the failure, as observation images of the semiconductor device (inspection information acquiring step). The layout information acquirer 12 acquires layout information indicating a configuration of nets or the like in the semiconductor device (layout information acquiring step). In Fig. 1, the layout information acquirer 12 acquires a layout image P3 as the layout information of the semiconductor device.

In Fig. 1, the inspection information supplying apparatus 20 is connected to the inspection information acquirer 11, and the pattern image P1 and the failure observed image P2 are supplied from the supplying apparatus 20 to the acquirer 11. This inspection information supplying apparatus 20 can be, for example, an emission microscope apparatus. In this case, the failure observed image P2 is an emission image. The inspection information supplying apparatus 20 can also be an OBIRCH apparatus. In this case, the failure observed image P2 is an OBIRCH image. Furthermore, the supplying apparatus 20 may also be any other type of semiconductor inspection apparatus than those.

Where the pattern image P1 and the failure observed image P2 are those preliminarily acquired by the semiconductor inspection apparatus, the inspection information supplying apparatus 20 is a data storage device storing those image data. The data storage device in this case may be one provided inside the failure analysis apparatus 10, or an external device. This configuration is useful in a case where observed images are taken and stored in advance by the semiconductor inspection apparatus and where software of failure analysis apparatus 10 is executed on another computer. In this case, works of the failure analysis can be performed as shared, without occupying the semiconductor inspection apparatus.

The pattern image P1 and the failure observed image P2 acquired by the semiconductor inspection apparatus such as the emission microscope apparatus or OBIRCH apparatus are acquired as images P1, P2 in a state in which the semiconductor device is mounted on a stage. For this reason, they are acquired as images aligned relative to each other. The coordinate system on the image in the images P1, P2 is set, for example, corresponding to the stage coordinate system in the semiconductor inspection apparatus.

On the other hand, the layout information supplying apparatus 30 is connected through a network to the layout information acquirer 12, and the layout image P3 is supplied from the supplying apparatus 30 to the acquirer 12. This layout information supplying apparatus 30 can be, for example, a workstation on which a CAD software application of a layout viewer to generate the layout image P3 from design information such as arrangement of elements and nets (wiring) constituting the semiconductor device, is running.

The failure analysis apparatus 10 is preferably configured to acquire the layout information other than the layout image P3, e.g., individual information of a plurality of nets contained in the semiconductor device, by performing communication with the layout information supplying apparatus 30 as occasion may demand. Alternatively, the failure analysis apparatus 10 may also be configured to retrieve the information together with the layout image P3 from the layout information acquirer 12. Furthermore, where the layout information necessary for the failure analysis of the semiconductor device is preliminarily read into the failure analysis apparatus 10, the layout information acquirer 12 is not needed.

In the present embodiment the failure analysis apparatus 10 is provided with the layout image display controller 15. This layout image display controller 15 is comprised of screen transfer software, e.g., an X terminal, and has a function of displaying the layout image P3 drawn by the layout information supplying apparatus 30, in a predetermined display window in the display device 40. However, the layout image display controller 15 of this configuration does not always have to be provided if it is not necessary.

The pattern image P1, failure observed image P2, and layout image P3 acquired by the inspection information acquirer 11 and by the layout information acquirer 12 are fed to the failure analyzer 13. The failure analyzer 13 is an analyzing means for analyzing a failure of the semiconductor device with reference to the failure observed image P2 and the layout information. The analysis screen display controller 14 is an information display controlling means for letting the display device 40 display the information about the analysis result of the failure of the semiconductor device obtained by the failure analyzer 13. The analysis screen display controller 14 displays the information about the analysis of the failure of the semiconductor device except for the analysis result in a predetermined analysis screen according to need.

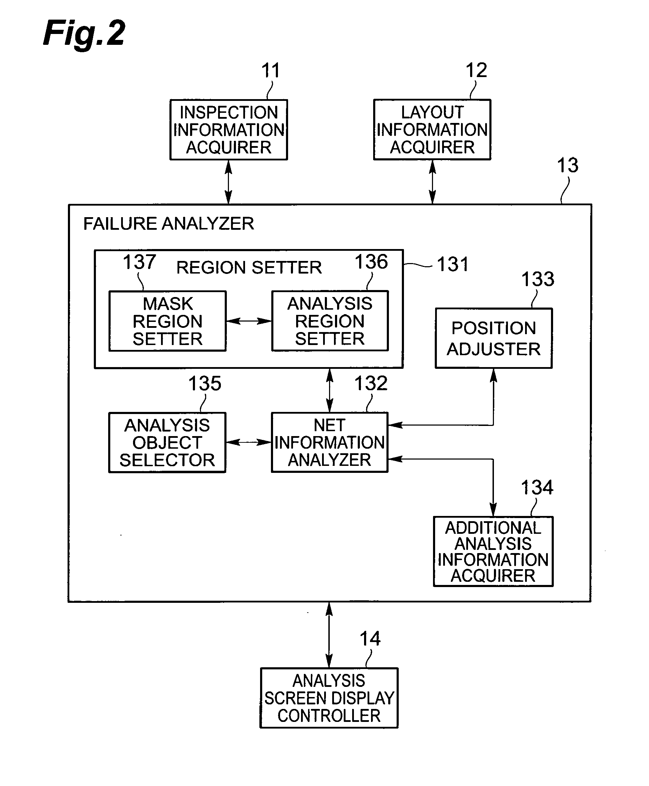

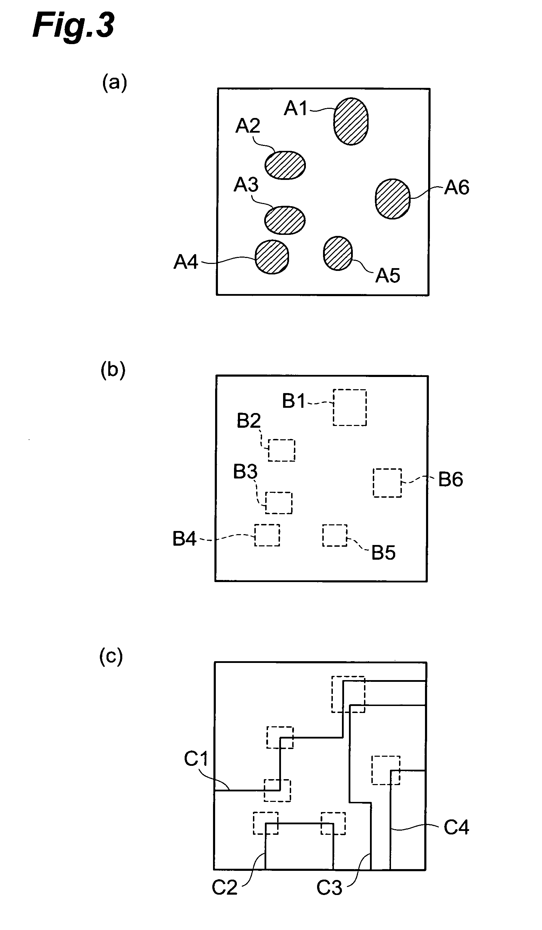

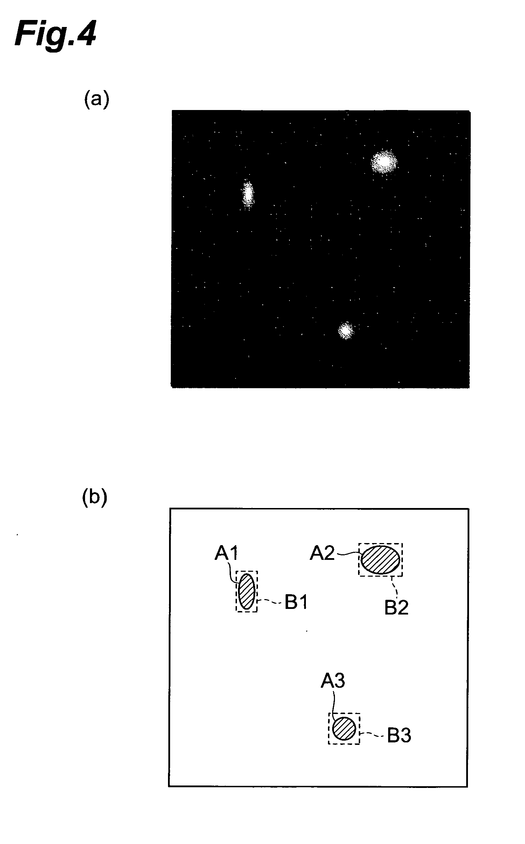

Fig. 2 is a block diagram showing a specific configuration of the failure analyzer 13 in the semiconductor failure analysis apparatus 10 shown in Fig. 1. The failure analyzer 13 of the present embodiment has a region setter 131 and a net information analyzer 132. Figs. 3 and 4 are drawings schematically showing a failure analysis method executed by the region setter 131 and the net information analyzer 132. Hereinafter, where the failure observed image and others are schematically illustrated, reaction regions, for example, such as emission regions in an emission image will be illustrated as hatched regions, for description's sake.

The region setter 131 is a setting means for setting an analysis region in correspondence to reaction information in the image P2, with reference to the failure observed image P2, for the semiconductor device as an analysis object. Let us consider an emission image acquired by an emission microscope apparatus, as an example of the failure observed image P2. For example, in an example shown in (a) in Fig. 3, six emission regions A1-A6 (reaction regions) exist as the reaction information referenced in the failure analysis, in an emission image. For this image, the region setter 131 sets six analysis regions B1-B6 corresponding to the emission regions, as shown in (b) in Fig. 3.

In the present embodiment, this region setter 131 has an analysis region setter 136 and a mask region setter 137. The analysis region setter 136 is a setting means for setting an analysis region by applying a predetermined intensity threshold to the failure observed image P2. For example, in a schematic example shown in (a) in Fig. 4, there are three emission parts in an emission image being the failure observed image P2.

With this failure observed image P2, the analysis region setter 136 compares an intensity distribution in the image P2 with the predetermined intensity threshold and selects, for example, pixels having respective intensity values not less than the intensity threshold. This results in extracting reaction regions A1-A3 as reaction information contained in the failure observed image P2, as shown in (b) in Fig. 4. When the failure observed image P2 herein is an emission image, the intensity distribution in the image P2 corresponds to an emission intensity distribution in the semiconductor device. The reaction regions A1-A3 extracted based on the intensity threshold correspond to the emission regions.

Furthermore, the analysis region setter 136 sets analysis regions B1-B3 used in the failure analysis of the semiconductor device, corresponding to the reaction regions A1-A3 extracted as described above. Such setting of analysis regions is preferably carried out by hand in accordance with operator's input through the input device 45 using a keyboard, a mouse, and so on. Alternatively, the analysis region setter 136 may be arranged to perform the setting automatically. There are no particular restrictions on the shape of the set analysis regions, but the shape to be set is preferably a rectangular region (reaction box) as shown in (b) in Fig. 3 and in (b) in Fig. 4, in terms of easiness of analysis or the like.

The mask region setter 137 is a setting means for setting a mask region used as a mask on the occasion of performing the failure analysis using the failure observed image. Using the failure observed image masked by the mask region set by the mask region setter 137, the analysis region setter 136 performs the extraction of the reaction regions and the setting of the analysis regions with reference to the masked failure observed image. The setting of the mask region and the masking process on the failure observed image are not essential and may be omitted if unnecessary. The setting method of the mask region, the processing method of the failure observed image, and others will be described later in more detail.

The net information analyzer 132 is arranged to perform the analysis with reference to the analysis region set by the analysis region setter 136, on a plurality of nets (wires) included in the layout of the semiconductor device. Specifically, it performs the analysis on the plurality of nets to extract a net passing the set analysis region (net information analyzing step). When the analysis region setter 136 sets a plurality of analysis regions, the net information analyzer 132 extracts a net passing each of the analysis regions and acquires a passage count of the net through the analysis regions, for the plurality of nets.

In the example described above, as shown in (c) in Fig. 3, four nets C1-C4 are extracted as nets passing the analysis regions, with the six analysis regions B1-B6 set by the analysis region setter 136. Among these nets C1-C4, the net C1 has the largest passage count of 3 through the analysis regions, the net C2 the passage count of 2, and each of the nets C3, C4 the passage count of 1.

In this analysis of net information, it is preferable to execute the analysis, while carrying out communication with the layout information supplying apparatus 30 through the layout information acquirer 12 as occasion may demand. An example of this configuration is such that the net information analyzer 132 is arranged to instruct the layout information supplying apparatus 30 to extract nets and to acquire the passage counts through the analysis regions, and to receive the result thereof.

In the present embodiment, an analysis object selector 135 is further provided relative to the net information analyzer 132. The analysis object selector 135 is a selecting means for selecting a layer as an object for the failure analysis in the net information analyzer 132, according to need, for a layer structure of the semiconductor device as an object for the failure analysis. This selection of the layer by the analysis object selector 135 can be performed, for example, with reference to an acquisition condition of the failure observed image or the like.

The analysis screen display controller 14 lets the display device 40 display the information such as the images necessary for the failure analysis, or the information obtained as the analysis result, as an analysis screen according to need. Particularly, in the present embodiment, the analysis screen display controller 14 lets the display device 40 display information indicating the analysis result by the failure analyzer 13 as described above, e.g., information about the reaction regions extracted by the analysis region setter 136 and the analysis regions set corresponding to the reaction regions, or information about the nets extracted by the net information analyzer 132 and the passage counts of the respective nets through the analysis regions (information display step).

The display of the analysis result may be implemented, for example, by displaying an image containing the analysis regions and nets as shown in (c) in Fig. 3, or by displaying names of the nets and counts of passages or the like. Specifically, the analysis screen display controller 14 preferably lets the display device 40 display a net list to display a list of nets extracted by the net information analyzer 132, as the analysis result. Where a plurality of analysis regions are set, it preferably lets the display device 40 display a net list to display a list of nets (e.g., names of nets) extracted by the net information analyzer 132, and the passage counts of the nets through the analysis regions (e.g., counts indicating passages), as the analysis result.

Where the analysis result is displayed by an image including the set analysis regions and the extracted nets, the extracted nets may be indicated by highlight display on the layout image, as shown in (c) in Fig. 3. It is also possible to use a variety of specific display methods; e.g., where one of the extracted nets is selected by manipulation of a mouse or the like, the analysis regions where the net passes are displayed by a different color. The reaction regions and the analysis regions may be displayed as follows; for example, as shown in (b) in Fig. 4, they are displayed by an image indicating both the reaction regions and analysis regions, or they are displayed by an image indicating either the reaction regions or the analysis regions.

The failure analyzer 13 of the present embodiment is provided with a position adjuster 133, corresponding to the configuration wherein the inspection information acquirer 11 acquires the pattern image P1 in addition to the failure observed image P2. The position adjuster 133 performs position adjustment between the observed images from the inspection information supplying apparatus 20 including the pattern image P1 and the failure observed image P2, and the layout image P3 from the layout information supplying apparatus 30, with reference to the pattern image P1 and the layout image P3 (position adjustment step). This position adjustment can be performed, for example, by a method of designating three appropriate points in the pattern image P1, further designating three corresponding points in the layout image P3, and performing the position adjustment from coordinates of those points.

The failure analyzer 13 is provided with an additional analysis information acquirer 134. The additional analysis information acquirer 134 acquires additional analysis information about the failure of the semiconductor device acquired by another analysis method than the aforementioned analysis method by the region setter 131 and the net information analyzer 132, from an external device or the like (additional analysis information acquiring step). This additional analysis information acquired is referenced in combination with the analysis result acquired by the net information analyzer 132.

The effects of the semiconductor failure analysis apparatus and semiconductor failure analysis method according to the above embodiment will be described below.

The semiconductor failure analysis apparatus 10 shown in Fig. 1, and the failure analysis method are arranged to acquire the failure observed image P2 obtained by inspecting the semiconductor device as an analysis object, and the necessary information about the layout of the semiconductor device, through the inspection information acquirer 11 and the layout information acquirer 12. Then the analysis region setter 136 sets the analysis region in correspondence to the reaction information caused by a failure in the failure observed image P2 (e.g., information about a reaction part, specifically, information about an emission part in an emission image or the like), and the analysis of the failure of the semiconductor device is performed. This configuration allows the apparatus and method to suitably execute the failure analysis of the semiconductor device using the failure observed image, with reference to the analysis region (e.g., a rectangular reaction box) set based on the failure observed image.

Furthermore, the above configuration is arranged as follows as to the setting of the analysis region on the basis of the failure observed image P2, which is carried out by the analysis region setter 136; the intensity threshold is applied to the intensity distribution in the failure observed image being a two-dimensional image having a plurality of pixels, to extract a reaction region corresponding to a reaction part or the like in the semiconductor device, and an analysis region is set based on this extracted reaction region. This makes it feasible to suitably set the analysis region used in the failure analysis and to securely and efficiently perform the failure analysis of the semiconductor device. There are no restrictions on the reaction arising from the failure, but the reaction includes, for example, photoelectron emission, thermal radiation, OBIRCH signal, TIVA signal, LIVA signal, SEI signal, and so on.

The failure analysis system 1 composed of the above-described semiconductor failure analysis apparatus 10, inspection information supplying apparatus 20, layout information supplying apparatus 30, and display device 40 substantializes a semiconductor failure analysis system capable of securely and efficiently carrying out the analysis of the failure of the semiconductor device with the use of the failure observed image P2.

A specific method for comparing the intensity distribution of the failure observed image P2 with the intensity threshold in extraction of the reaction region is preferably an appropriate comparison method according to a type of the failure observed image or the like. For example, where the failure observed image P2 is an emission image, an appropriate method can be a method of extracting the reaction region by pixels with intensity values of not less than the intensity threshold in the image, as described above.

The configuration of extracting the reaction region by applying the intensity threshold as described above is also effective to the configuration of automatically setting the analysis region in the failure observed image so as to further improve the efficiency of the failure analysis. Namely, by preliminarily preparing an extraction condition such as the intensity threshold used in the extraction of the reaction region in the analysis region setter 136, it becomes feasible to automatically execute the extraction of the reaction region for the failure observed image P2 fed through the inspection information acquirer 11. By further preparing the setting method of the analysis region corresponding to the reaction region in the analysis region setter 136, it becomes feasible to automatically execute the setting of the analysis region as well.

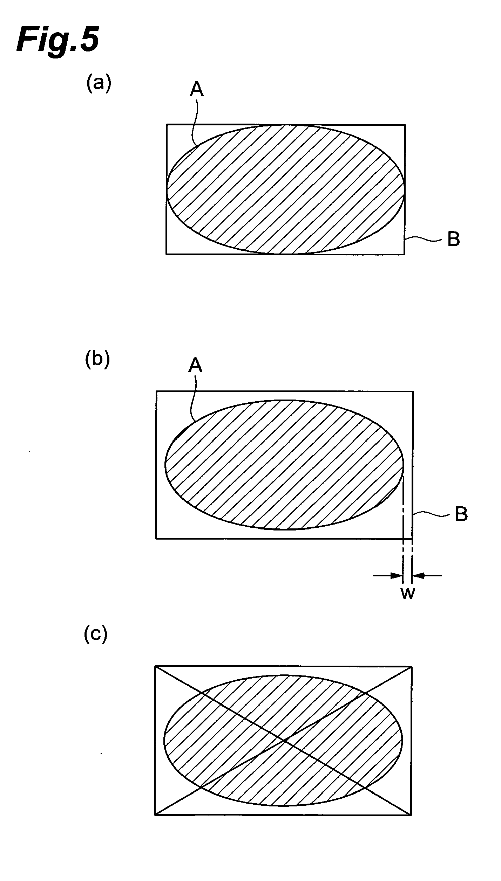

Fig. 5 is a drawing showing examples of setting methods of an analysis region corresponding to a reaction region. The example shown in (a) in Fig. 5 uses a method of defining the analysis region in a rectangular shape and setting the analysis region B so as to circumscribe the reaction region A extracted in the failure observed image. The example shown in (b) in Fig. 5 uses a method of adding a certain blank space to the reaction region A, and the analysis region B is set in a state in which a blank space of a width w is added to each of the left, right, upper, and lower sides (periphery) of the reaction region A. Such addition of the blank space is effective, for example, to cases such as a case where the analysis region needs to be set fairly wider than the reaction region in the failure observed image P2, in consideration of the positional accuracy of the stage or the like on which the semiconductor device is mounted during acquisition of the observed image. The setting method of the analysis region may be any one of various methods other than these methods.

In a case where the reaction region A and the analysis region B are displayed on the display device 40, diagonal lines may also be drawn together with a rectangular outline for the analysis region B, as shown in (c) in Fig. 5. When the diagonal lines of the analysis region B are displayed in this manner, it becomes easy to check whether the center of the analysis region B agrees with the center of the reaction region A.

A preferred configuration for extracting the reaction region in the analysis region setter 136 is such that, for a reaction region extracted with the application of the intensity threshold, an area of the reaction region is further compared with a predetermined area threshold to select the reaction region to be used in the setting of the analysis region, and the analysis region is set corresponding to the selected reaction region.

When the reaction region to be used in the setting of the analysis region is extracted and selected by applying the area threshold in addition to the intensity threshold for the failure observed image P2 as described above, it becomes feasible to set the analysis region after a region unnecessary for the failure analysis is eliminated out of the extracted reaction regions. This improves the certainty of the failure analysis of the semiconductor device using the failure observed image.

Specifically, for example, the intensity threshold is applied to the failure observed image to extract pixels with intensity values of not less than the intensity threshold, as reaction pixels. Then each region consisting of continuous reaction pixels (e.g., a pixel region in which reaction pixels are adjacent horizontally or vertically or obliquely) is defined as a region in the distribution of reaction pixels in the failure observed image, and an area (e.g., the number of pixels) thereof is determined, and when the area is not less than the area threshold, the region is defined as a reaction region. This permits us to effectively remove an unnecessary region, for example, a small region due to noise or dust.

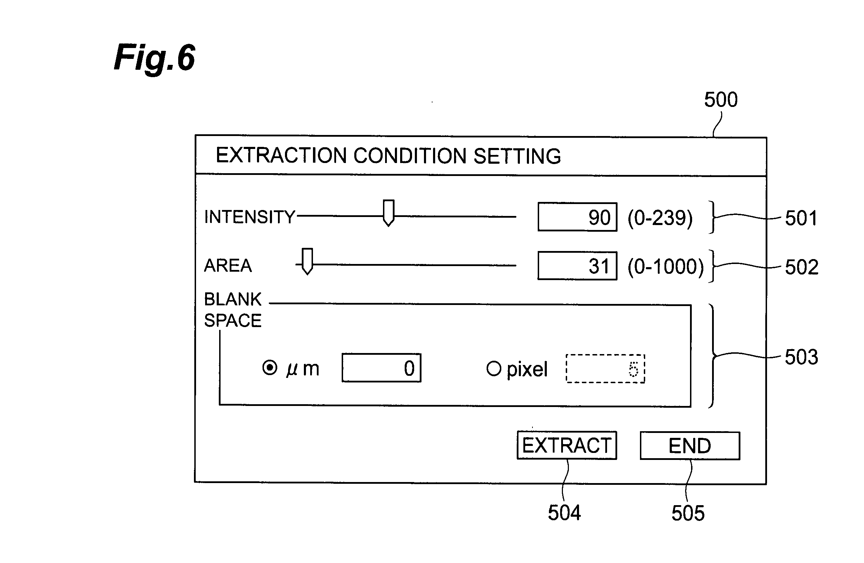

Conditions for the extraction of the reaction region and analysis region can be set, for example, with a setting window shown in Fig. 6. This setting window 500 is provided with an intensity threshold setting region 501 for setting of the intensity threshold, an area threshold setting region 502 for setting of the area threshold, and a blank space setting region 503 for setting of the width w of the blank space added upon setting of the analysis region.

Among the above setting regions 501-503, the blank space setting region 503 permits us to select either µm (micrometer) or pixel (picture element) as a unit for setting of the width w of the blank space. Below the setting regions 501-503, there are an extract button 504 for indicating the extraction of the region, and an end button 505 for ending the extraction of the region.

In the semiconductor failure analysis apparatus 10 of the above embodiment, the failure analyzer 13 is provided with the net information analyzer 132 for analyzing a plurality of nets included in the layout of the semiconductor device, with reference to the layout information, to extract a net passing the analysis region set in the analysis region setter 136. When the net information is analyzed with reference to the analysis regions as described above, a net with a high possibility of a failure (suspect failure net) can be estimated out of the huge number of nets in the semiconductor device by the net passing the analysis region. Therefore, it becomes feasible to securely and efficiently perform the failure analysis of the semiconductor device using the failure observed image P2.

Here the reaction information arising from the failure in the failure observed image P2 contains not only a case where the reaction part itself is a failure part, but also a part where reaction occurs due to another failure part (e.g., failure net). The above configuration permits the apparatus to suitably perform narrowing and estimation with the use of the analysis region, for such failure nets or the like.

Concerning the analysis region set in correspondence to the reaction information in the failure observed image P2, a preferred configuration is as follows if the region setter 131 sets a plurality of analysis regions; the net information analyzer 132 extracts a net passing each of the analysis regions, from the plurality of nets included in the layout of the semiconductor device, and acquires passage counts of respective nets through the analysis regions. This configuration permits the apparatus to estimate a net with a high possibility of a failure in the semiconductor device, by extracting a net with a large passage count through the analysis regions. Therefore, it becomes feasible to more securely and efficiently perform the analysis of the failure of the semiconductor device with the use of the failure observed image P2.

Concerning the setting of the analysis regions in the analysis region setter 136, the analysis regions are preferably set in the layout coordinate system corresponding to the layout of the semiconductor device. When the analysis regions extracted from the failure observed image P2 are expressed in the layout coordinate system on the layout information side instead of the coordinate system on the image on the inspection information side as described above, the scope of application of the analysis regions can be expanded. This can increase degrees of freedom for specific analysis methods in the failure analysis of the semiconductor device using the analysis regions. Alternatively, the analysis regions may be set in the coordinate system on the image. The coordinate system on the image in the failure observed image P2 or the like is set, for example as described above, corresponding to the stage coordinate system in the semiconductor inspection apparatus.

The processing corresponding to the failure analysis method executed in the semiconductor failure analysis apparatus 10 shown in Fig. 1 can be implemented by a semiconductor failure analysis program for letting a computer execute the semiconductor failure analysis. For example, the failure analysis apparatus 10 can be constructed of a CPU for executing each of software programs necessary for the processing of semiconductor failure analysis, a ROM storing the software programs, and a RAM temporarily storing data during execution of the programs. The aforementioned failure analysis apparatus 10 can be substantialized by letting the CPU execute a predetermined failure analysis program in this configuration.

The program for letting the CPU execute each of processes for the semiconductor failure analysis can be recorded in a computer-readable recording medium and distributed in that form. Such recording media include, for example, magnetic media such as hard disks and flexible disks, optical media such as CD-ROM and DVD-ROM, magnetooptic media such as floptical disks, or hardware devices such as RAM, ROM, and semiconductor nonvolatile memories specially arranged to execute or store program commands.

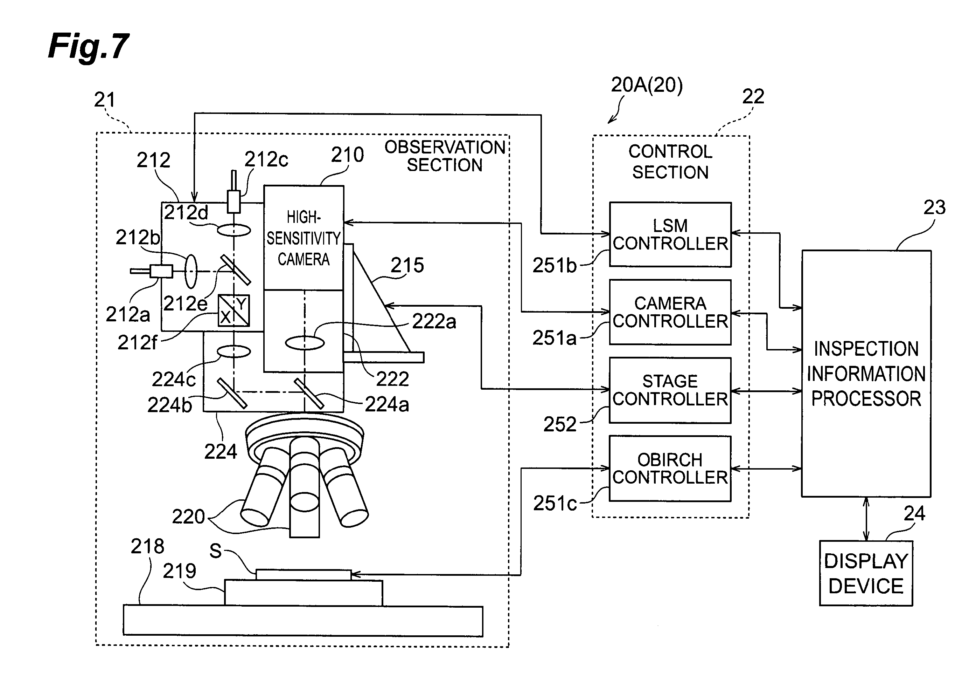

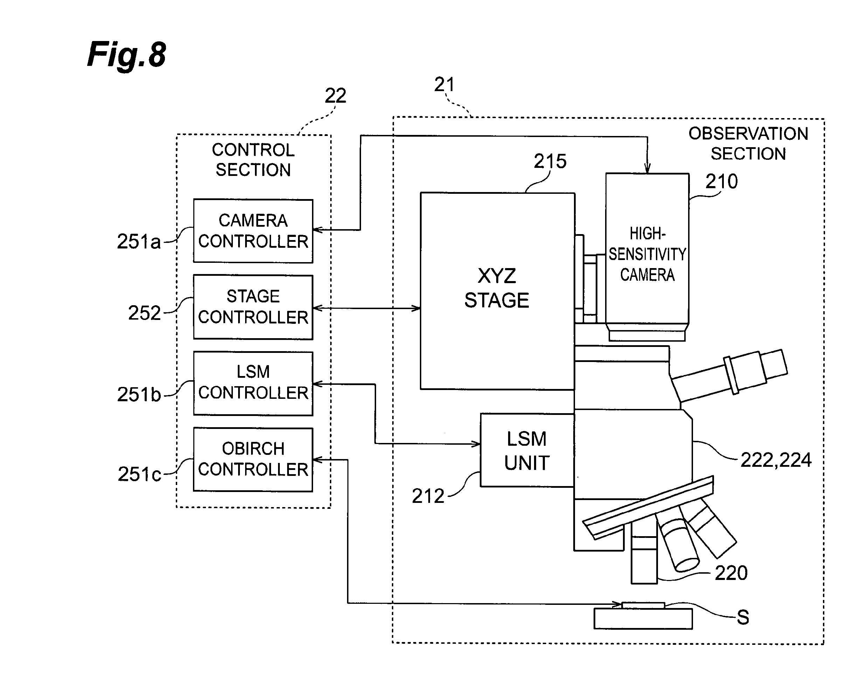

Fig. 7 is a configuration diagram showing an example of semiconductor inspection apparatus which can be applied as the inspection information supplying apparatus 20 shown in Fig. 1. Fig. 8 is a configuration diagram as a side view of the semiconductor inspection apparatus shown in Fig. 7.

The semiconductor inspection apparatus 20A according to the present configuration example comprises an observation section 21 and a control section 22. A semiconductor device S as an inspection object (analysis object to be analyzed by the failure analysis apparatus 10) is mounted on a stage 218 provided in the observation section 21. In the present configuration example, the apparatus is further provided with a test fixture 219 for applying an electric signal or the like necessary for the failure analysis to the semiconductor device S. The semiconductor device S is arranged, for example, so that a back face thereof faces an objective lens 220.

The observation section 21 has a high-sensitivity camera 210 set in a dark box, a laser scan optic (LSM: Laser Scanning Microscope) unit 212, optical systems 222, 224, and an XYZ stage 215. Among these, the camera 210 and LSM unit 212 are image acquiring means for acquiring an observed image of the semiconductor device S (pattern image P1 or failure observed image P2).

The optical systems 222, 224, and the objective lens 220 disposed on the semiconductor device S side of the optical systems 222, 224 constitute a lightguide optical system for guiding an image (optical image) from the semiconductor device S to the image acquiring means. In the present configuration example, as shown in Figs. 7 and 8, a plurality of objective lenses 220 having their respective magnifications different from each other are arranged so as to be switchable from one to another. The test fixture 219 is an inspecting means for performing an inspection for the failure analysis of the semiconductor device S. The LSM unit 212 also has a function as an inspecting means, as well as the function as the aforementioned image acquiring means.

The optical system 222 is a camera optical system for guiding light from the semiconductor device S incident thereto through the objective lens 220, to the camera 210. The camera optical system 222 has an imaging lens 222a for forming an image enlarged at a predetermined magnification by the objective lens 220, on a light-receiving surface inside the camera 210. A beam splitter 224a of the optical system 224 is interposed between the objective lens 220 and the imaging lens 222a. The high-sensitivity camera 210 to be used is, for example, a cooled CCD camera or the like.

In this configuration, light from the semiconductor device S as a failure analysis object is guided through the optical system including the objective lens 220 and the camera optical system 222, to the camera 210. Then the camera 210 acquires an observed image such as the pattern image P1 of the semiconductor device S. It is also possible to acquire an emission image being a failure observed image P2 of the semiconductor device S. In this case, light generated from the semiconductor device S in a state in which a voltage is applied thereto by the test fixture 219 is guided through the optical system to the camera 210, and the camera 210 acquires an emission image.

The LSM unit 212 has a laser input optical fiber 212a for emitting an infrared laser beam, a collimator lens 212b for collimating the laser beam emitted from the optical fiber 212a, a beam splitter 212e for reflecting the laser beam collimated by the lens 212b, and an XY scanner 212f for emitting the laser beam reflected by the beam splitter 212e, to the semiconductor device S side, while scanning it in XY directions.

The LSM unit 212 further has a condenser lens 212d for condensing light incident thereto from the semiconductor device S side through the XY scanner 212f and transmitted by the beam splitter 212e, and a detection optical fiber 212c for detecting the light condensed by the condenser lens 212d.

The optical system 224 is an optical system for the LSM unit which guides light between the semiconductor device S and objective lens 220, and the XY scanner 212f of the LSM unit 212. The optical system 224 for the LSM unit has a beam splitter 224a for reflecting part of light incident thereto from the semiconductor device S through the objective lens 220, a mirror 224b for changing an optical path of the light reflected by the beam splitter 224a, into an optical path directed toward the LSM unit 212, and a lens 224c for condensing the light reflected by the mirror 224b.

In this configuration, the infrared laser beam emitted from a laser light source through the laser input optical fiber 212a passes the lens 212b, beam splitter 212e, XY scanner 212f, optical system 224, and objective lens 220 to irradiate the semiconductor device S.

Reflectively scattered light of this incident beam from the semiconductor device S reflects a circuit pattern provided in the semiconductor device S. The reflected light from the semiconductor device S passes through an optical path opposite to that of the incident beam to reach the beam splitter 212e, and passes through the beam splitter 212e. Then the light passing through the beam splitter 212e is incident through the lens 212d into the detection optical fiber 212c to be detected by a photodetector connected to the detection optical fiber 212c.

An intensity of the light detected through the detection optical fiber 212c by the photodetector is an intensity reflecting the circuit pattern provided in the semiconductor device S, as described above. Therefore, as the area on the semiconductor device S is scanned by X-Y scanning with the infrared laser beam by the XY scanner 212f, the pattern image P1 or the like of the semiconductor device S can be acquired as a clear image.

The control section 22 has a camera controller 251a, an LSM controller 251b, an OBIRCH controller 251c, and a stage controller 252. Among these, the camera controller 251a, LSM controller 251b, and OBIRCH controller 251c constitute an observation controlling means for controlling operations of the image acquiring means, inspection means, etc. in the observation section 21, thereby controlling the acquisition of the observed image of the semiconductor device S, the setting of observation conditions, etc. executed in the observation section 21.

Specifically, the camera controller 251a and LSM controller 251b control the operations of the high-sensitivity camera 210 and the LSM unit 212, respectively, to control the acquisition of the observed image of the semiconductor device S. The OBIRCH controller 251c is a controller for acquiring an OBIRCH (Optical Beam Induced Resistance Change) image which can be used as a failure observed image, and extracts an electric current change or the like in the semiconductor device S occurring during the scanning with the laser beam.

The stage controller 252 controls the operation of the XYZ stage 215 in the observation section 21, thereby controlling setting of an observed portion in the semiconductor device S as an inspection portion by the present inspection apparatus 20A, position adjustment thereof, focusing, and so on.

An inspection information processor 23 is provided for these observation section 21 and control section 22. The inspection information processor 23 performs such processing as data collection of the observed image of the semiconductor device S acquired in the observation section 21, supply of inspection information including the pattern image P1 and failure observed image P2, to the failure analysis apparatus 10 (cf. Fig. 1), and so on. It is also possible to adopt a configuration wherein a display device 24 is connected to this inspection information processor 23 as occasion may demand. It is noted that Fig. 8 is illustrated without illustration of the inspection information processor 23 and the display device 24.

The semiconductor failure analysis apparatus, failure analysis method, and failure analysis program according to the present invention will be described in further detail.

In the semiconductor failure analysis apparatus 10 shown in Figs. 1 and 2, the analysis region setter 136 sets an analysis region and the failure analysis is carried out as to nets or the like in a semiconductor device with reference to this analysis region. When this analysis region is set as a region on the layout coordinate system as described above, the scope of application of the analysis region can be expanded; e.g., it becomes feasible to share the region data with the other data.

An example of such application of the analysis region is a method of defining as a standard an observed image acquired from a nondefective semiconductor device, and performing a masking process necessary for the failure observed image P2 in inspection of another semiconductor device, with reference to this standard observed image.

In this case, specifically, for example, the mask region setter 137 of the failure analyzer 13 uses a standard observed image being an observed image containing reaction information of a standard semiconductor device (e.g., a nondefective semiconductor device), and compares an intensity distribution in the standard observed image with a predetermined intensity threshold to extract a standard reaction region. An applicable method is then to set a mask region corresponding to the extracted standard reaction region. In connection therewith, the analysis region setter 136 is preferably arranged to perform the extraction of the reaction region and the setting of the analysis region, using the failure observed image P2 masked with the mask region set by the mask region setter 137.

When the mask region is set corresponding to a standard reaction region arising from nondefective emission or the like, using the standard observed image acquired from an object of a standard semiconductor device, it becomes feasible to set the analysis region after exception of the region not arising from a failure, out of the reaction regions extracted from the failure observed image. This improves the certainty of the failure analysis of the semiconductor device using the failure observed image.

For example, in a case where an analysis of open failure of the semiconductor device is carried out, the analysis of emission can be performed effectively in an operating state of LSI; in such analysis, emission often occurs in regions except for intrinsic failure parts. In addition thereto, emission can occur in regions except for the failure parts because of other causes. In such cases, the failure analysis for the intrinsic failure parts can be securely executed by performing the analysis of emission for the nondefective semiconductor device and performing the masking process for the failure observed image P2 with reference to the result of the analysis.

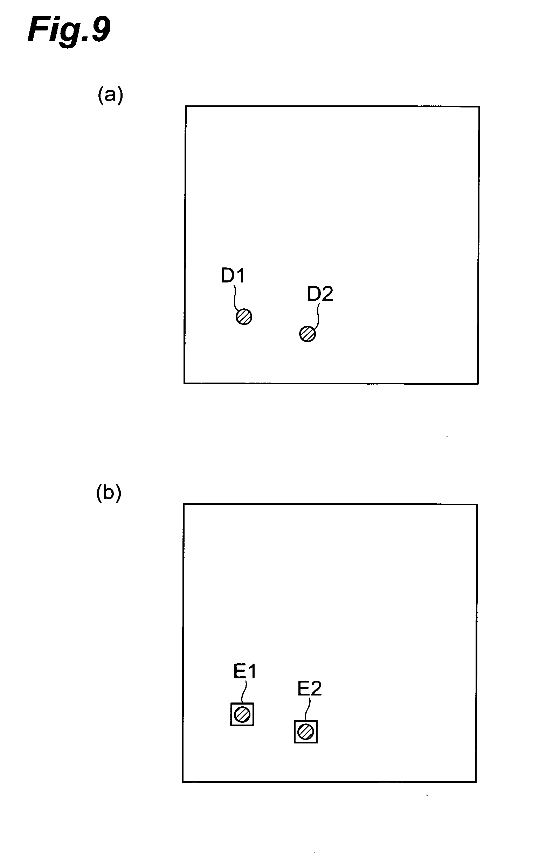

This masking process for the failure observed image P2 can be specifically executed, for example, by a method shown in Figs. 9 to 11. Fig. 9 (a) shows reaction regions extracted from a standard observed image of a nondefective semiconductor device. In this example, two regions are extracted as standard reaction regions D1, D2 arising from nondefective emission or the like. For these standard reaction regions D1, D2, as shown in (b) in Fig. 9, rectangular regions E1, E2 corresponding to the standard reaction regions D1, D2 are set by a method similar to the setting of the analysis region in the failure observed image. These regions E1, E2 are used as mask regions in the failure analysis of another semiconductor device.

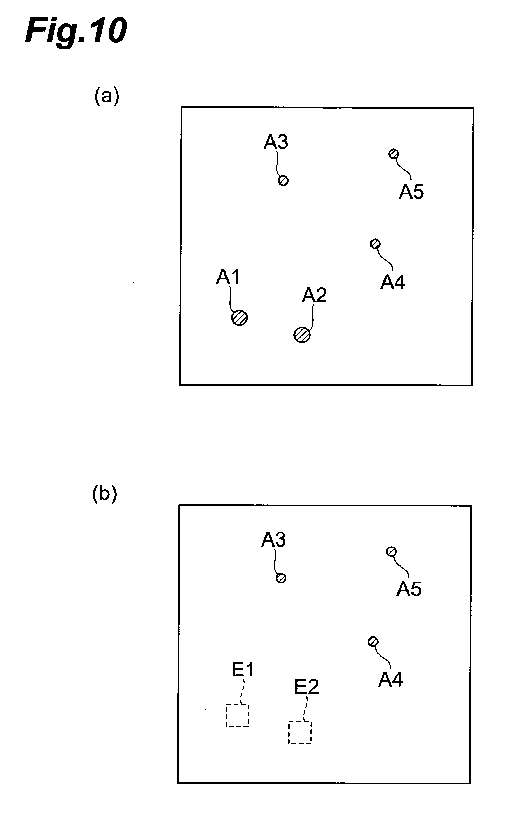

Fig. 10 (a) shows reaction regions extracted from a failure observed image P2 of a semiconductor device as an object for failure analysis. In this example, five regions are extracted as reaction regions A1-A5. The masking process is carried out to process the failure observed image, for example, by a method of applying the mask regions E1, E2 set with reference to the standard observed image, to the failure observed image and setting intensity values of the respective pixels in those regions to 0 or erasing the reaction regions in the mask regions.

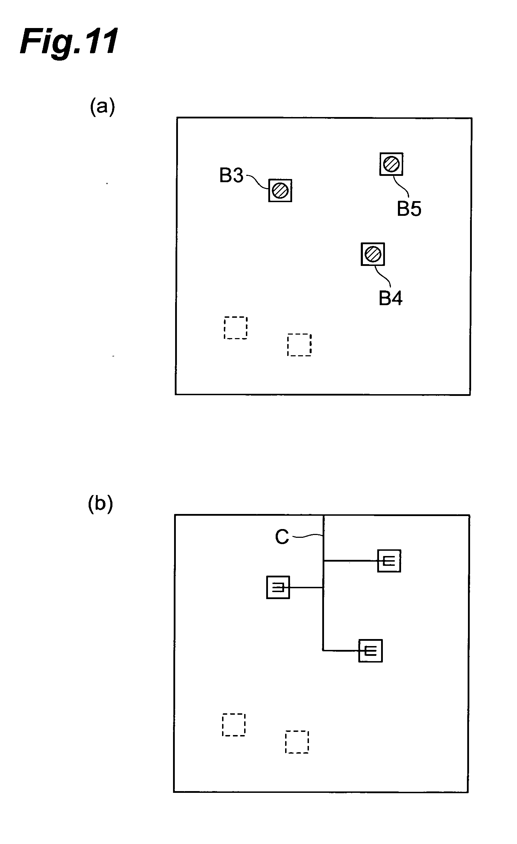

This results in eliminating two regions A1, A2 out of the extracted reaction regions A1-A5, as nondefective emission in view of the mask regions E1, E2, as shown in (b) in Fig. 10, whereby three remaining regions A3-A5 are defined as objects for failure analysis hereinafter. Namely, the failure observed image including the reaction regions A3-A5 is subjected to image processing such as enhancement of the reaction regions according to need and thereafter, as shown in (a) in Fig. 11, analysis regions B3-B5 are set corresponding to the respective reaction regions A3-A5. Then the analysis is carried out for a net C included in the layout of the semiconductor device, with reference to the analysis regions B3-B5, as shown in (b) in Fig. 11.

When each region such as the analysis regions is set in the layout coordinate system, it is easy to achieve the correspondence of coordinate system between the standard observed image and the failure observed image. Therefore, it becomes feasible to make mutual reference among various regions such as the mask regions set in the standard observed image, and the reaction regions and the analysis regions set in the failure observed image.

How to designate such a mask region may be selected from a variety of specific methods, e.g., a method of providing each region with a mask attribute. In a case where there are portions preliminarily expected to emit light, in terms of the layout in the semiconductor device, a mask region may be preliminarily set for such portions in the layout coordinate system. Concerning the masking process for the failure observed image, it is preferable to perform the masking process by carrying out processing of the image on a software basis as described above. In addition to such methods, the masking process may also be carried out on a hardware basis, for example, by a method of disposing a filter for masking (e.g., a liquid crystal mask a pattern of which can be controlled) between the semiconductor device and an image pickup device during acquisition of the observed image.

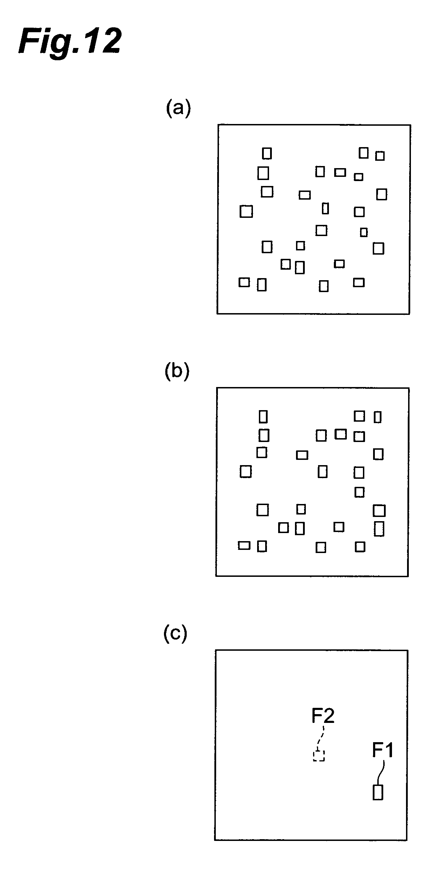

When the failure analysis is performed using the standard observed image acquired from the standard semiconductor device such as a nondefective device, together with the failure observed image, it is also effective to adopt a method of performing the failure analysis process by calculating a difference between the standard observed image and the failure observed image, for example, as shown in Fig 12. In this example, the difference is calculated between analysis regions in a standard observed image of a nondefective device shown in (a) in Fig. 12 and analysis regions in a failure observed image of a defective device shown in (b) in Fig. 12, and analysis regions including a common overlay portion are excluded out of the analysis regions set in the respective images. This results in extracting two regions F1, F2, analysis region F1 (solid line) with OFF in the nondefective device and ON in the defective device and analysis region F2 (dashed line) with ON in the nondefective device and OFF in the defective device, as inconsistent portions, as shown in (c) in Fig. 12.

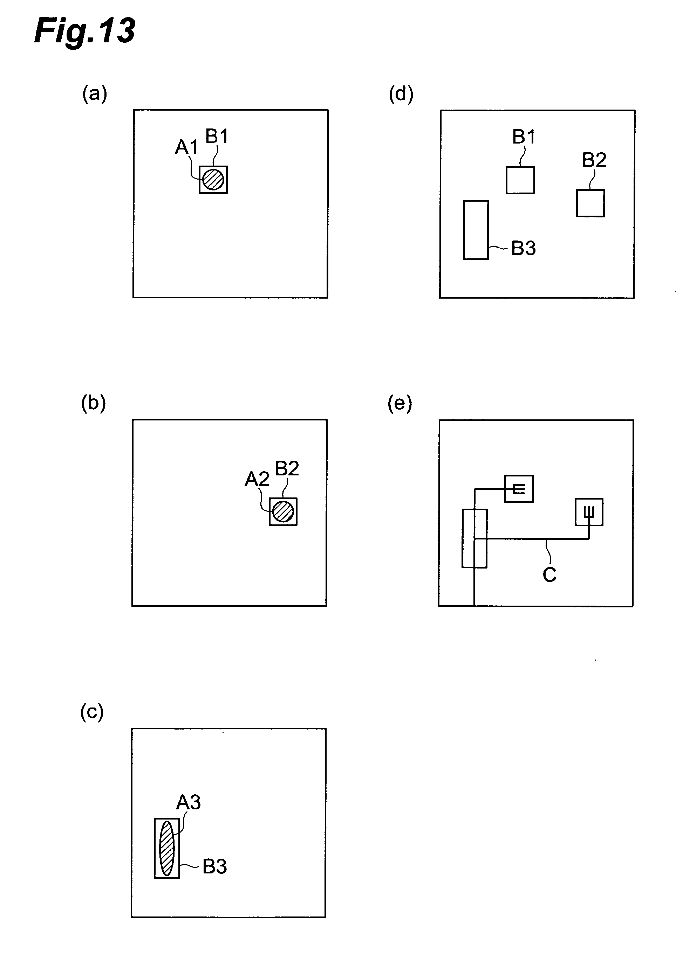

Figs. 3 and 4 illustrate the emission image as an example of the failure observed image P2 used in the failure analysis, but the similar failure analysis method can also be applied, for example, to cases where the failure observed image P2 is another observed image such as an OBIRCH image. The failure observed image can be an image obtained by a single observation under a single condition, but is not limited to it; for example, as shown in Fig. 13, the failure observed image may be one generated by superimposing a plurality of failure observed images acquired under respective different conditions.

In the example shown in Fig. 13, Fig. 13 (a) shows a reaction region A1 extracted from an emission image acquired under a first condition, and an analysis region B1. Fig. 13 (b) shows a reaction region A2 extracted from another emission image acquired under a second condition different from the first condition, and an analysis region B2. Fig. 13 (c) shows a reaction region A3 extracted from an OBIRCH image, and an analysis region B3.

With these three types of failure observed images shown in (a) to (c) in Fig. 13, these images (analysis regions) are superimposed as shown in (d) in Fig. 13. This enables us to execute the failure analysis for net C by making use of the three analysis regions, the analysis regions B1-B3, as shown in (e) in Fig. 13. In such superposition of the failure observed images (superposition of analysis regions), it is also preferable to use the layout coordinate system as a common coordinate system to them.

In the failure analysis using the analysis regions, it is preferable to designate a layer as an analysis object in a semiconductor device, according to an occurrence situation of reaction in the semiconductor device, an image acquisition condition, and so on. In the semiconductor failure analysis apparatus 10 shown in Figs. 1 and 2, the failure analyzer 13 is provided with the analysis object selector 135 for selecting a layer as an object for the failure analysis, for a layer structure of a semiconductor device, as a means for designating the layer. This configuration permits us to select and designate a layer as an object for the failure analysis according to need, with reference to a specific acquisition method of the failure observed image or the like. This improves the certainty of the failure analysis of the semiconductor device using the failure observed image. One of such methods is specifically a method of designating a desired layer for extraction of nets passing in analysis regions in performing extraction of nets while setting the analysis regions, and designating all the layers in the failure analysis. Such layer selection may be a method of selecting one layer, or a method of selecting multiple layers.

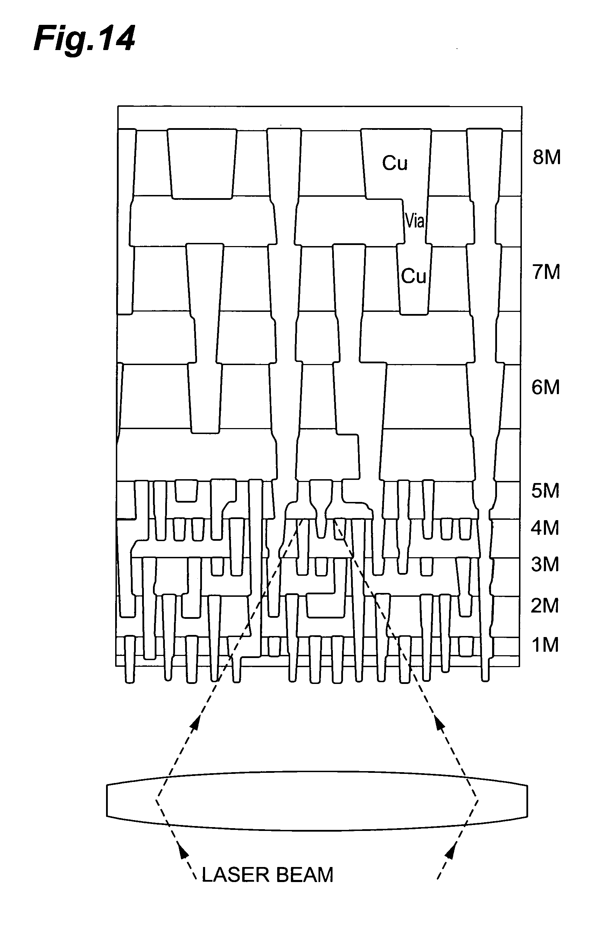

Fig. 14 is a drawing showing an example of selection of a layer as an analysis object. Where an OBIRCH image is used as a failure observed image, as shown in Fig. 14, a reach of laser beam for measurement is limited in the layer structure of the semiconductor device. For example, when the analysis is performed from the front surface side of the semiconductor device, the laser beam is interrupted by wide power-supply lines or the like; therefore, the analysis from the back side is indispensable. On the other hand, where the laser beam is injected from the back side of the semiconductor device, the laser beam can reach only the fourth layer at best from the bottom. Therefore, where the failure observed image is an OBIRCH image, it is preferable to limit the analysis object to layers within the reach of the laser beam.

When the layout coordinate system is applied to the setting of the analysis regions as described above, the observed images of the semiconductor device, such as the pattern image P1 and the failure observed image P2, may also be stored after their coordinates are transformed into the layout coordinate system. In this case, it is preferable to effect the position adjustment between the observed images P1, P2 and the layout image P3.

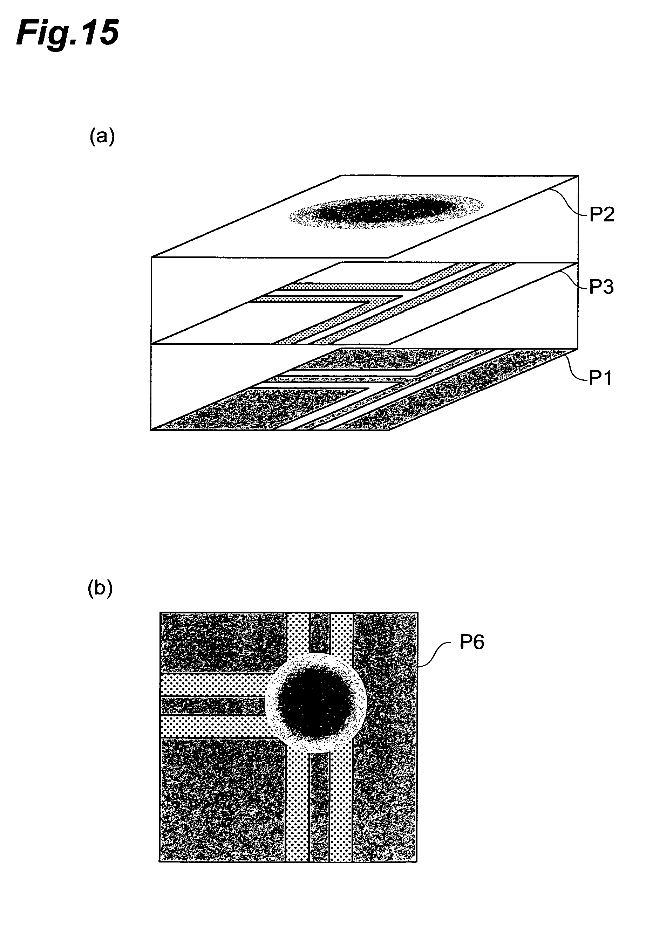

Fig. 15 is a drawing schematically showing the correspondence among the observed images and the layout image of the semiconductor device, wherein (a) in Fig. 15 shows a correspondence relation among the pattern image P1, the failure observed image P2, and the layout image P3 and (b) in Fig. 15 shows a superimposed image P6 in which those pattern image P1, layout image P3, and failure observed image P2 are superimposed in this order. As shown in this Fig. 15, the pattern image P1 acquired as an observed image, and the layout image P3 of the semiconductor device have a certain correspondence relation. Therefore, the position adjuster 133 of the failure analyzer 13 is able to perform the position adjustment of images with reference to the correspondence relation of each part between the pattern image P1 and the layout image P3.

When the position adjustment with the layout image P3 is executed using the pattern image P 1 acquired in a state in which it is adjusted in position with respect to the failure observed image P2, as described above, the accuracy of the failure analysis can be improved on the nets or the like included in the layout of the semiconductor device. A specific method of such position adjustment can be one of various methods according to need, e.g., rotation of the pattern image P1 (θ correction), movement of the layout image P3 (fine adjustment of position), and zooming of the layout image (enlargement/reduction).

Concerning the failure analysis of the semiconductor device using the analysis region, the region setter 131 of the failure analyzer 13 is preferably arranged to be able to set an attribute for the analysis region. In this case, the net information analyzer 132 may be arranged to determine whether the analysis region is to be used in extraction of nets (or to be used in the failure analysis), with reference to the attribute set for the analysis region.

Furthermore, where there are a plurality of analysis regions set, the region setter 131 is preferably arranged to be able to set attributes for the respective analysis regions. In this case, the net information analyzer 132 may be arranged to determine whether each of the analysis regions is to be used in the extraction of nets and the acquisition of passage counts, with reference to the attributes set for the respective analysis regions.

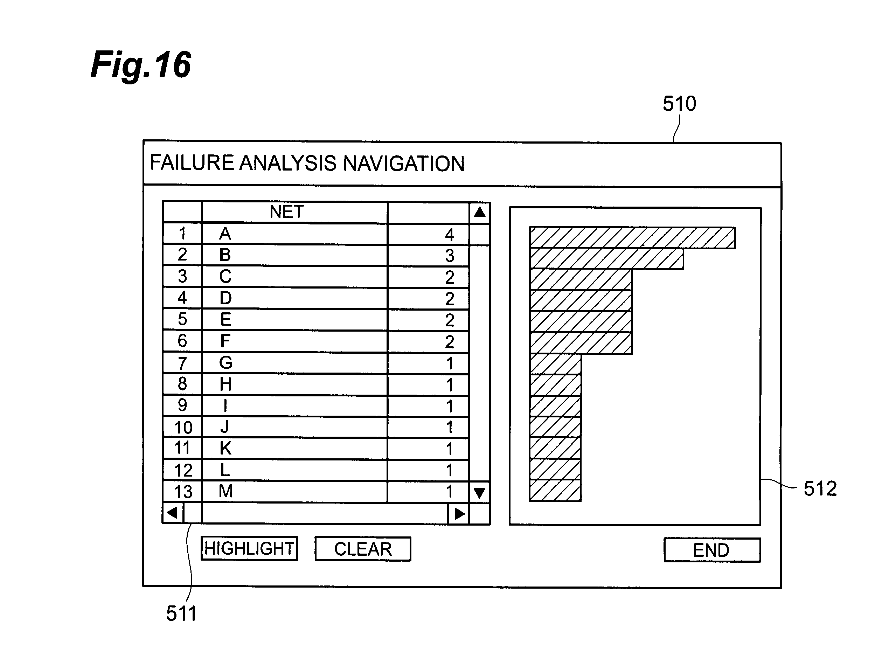

The display on the display device 40 is preferably as follows for the analysis result of the failure analysis carried out using the analysis regions; as described above, in addition to the method of displaying the image including the analysis regions and nets as shown in (c) in Fig. 3, the display device 40 displays a net list to display a list of nets extracted by the net information analysis, or further passage counts of the respective nets through the analysis regions. This list of nets or the like can be displayed, for example, using a list display window of nets shown in Fig. 16. The display window 510 shown in Fig. 16 has a net list display region 511 located on the left side of the screen, and a graph display region 512 displaying a graph (or histogram) of the list of nets, which is located on the right side of the screen. The use of such display window 510 facilitates operator's understanding of the analysis result.

The semiconductor failure analysis apparatus, failure analysis method, and failure analysis program according to the present invention are not limited to the above-described embodiments and configuration examples, but can be modified in various ways. For example, the setting method of the analysis region set corresponding to the reaction region extracted from the failure observed image is not limited to the aforementioned example of setting the rectangular region (reaction box), but may be selected from a variety of specific setting methods.

The semiconductor failure analysis apparatus according to the above embodiment is a semiconductor failure analysis apparatus for analyzing a failure of a semiconductor device, comprising: (1) inspection information acquiring means for acquiring a failure observed image containing reaction information arising from a failure, acquired by conducting an inspection about the failure, as an observed image of the semiconductor device; and (2) failure analyzing means for analyzing the failure of the semiconductor device with reference to the failure observed image and layout information of the semiconductor device; (3) wherein the failure analyzing means has analysis region setting means for comparing an intensity distribution in the failure observed image with a predetermined intensity threshold to extract a reaction region as the reaction information, and for setting an analysis region used in the analysis of the failure of the semiconductor device, in correspondence to the reaction region.

The semiconductor failure analysis method is a semiconductor failure analysis method of analyzing a failure of a semiconductor device, comprising: (1) an inspection information acquiring step of acquiring a failure observation image containing reaction information caused by a failure, acquired by conducting an inspection about the failure, as an observed image of the semiconductor device; and (2) a failure analyzing step of analyzing the failure of the semiconductor device with reference to the failure observed image and layout information of the semiconductor device; (3) wherein the failure analyzing step comprises an analysis region setting step of comparing an intensity distribution in the failure observed image with a predetermined intensity threshold to extract a reaction region as the reaction information, and setting an analysis region used in the analysis of the failure of the semiconductor device, in correspondence to the reaction region.

The semiconductor failure analysis program is a program for letting a computer execute a semiconductor failure analysis of analyzing a failure of a semiconductor device, the program letting the computer execute: (1) an inspection information acquiring process of acquiring a failure observed image containing reaction information arising from a failure, acquired by conducting an inspection about the failure, as an observed image of the semiconductor device; and (2) a failure analyzing process of analyzing the failure of the semiconductor device with reference to the failure observed image and layout information of the semiconductor device; (3) wherein the failure analyzing process comprises an analysis region setting process of comparing an intensity distribution in the failure observed image with a predetermined intensity threshold to extract a reaction region as the reaction information, and setting an analysis region used in the analysis of the failure of the semiconductor device, in correspondence to the reaction region.

In the above configuration, concerning the layout information of the semiconductor device, the failure analysis apparatus preferably further comprises layout information acquiring means for acquiring the layout information of the semiconductor device. Similarly, the failure analysis method preferably further comprises a layout information acquiring step of acquiring the layout information of the semiconductor device. Similarly, the failure analysis program preferably lets the computer further execute a layout information acquiring process of acquiring the layout information of the semiconductor device.

The aforementioned failure analysis apparatus is preferably configured as follows; the analysis region setting means compares an area of the reaction region extracted, with a predetermined area threshold to select the reaction region used in the setting of the analysis region, and sets the analysis region in correspondence to the reaction region selected.

Similarly, the failure analysis method is preferably configured as follows; the analysis region setting step comprises comparing an area of the reaction region extracted, with a predetermined area threshold to select the reaction region used in the setting of the analysis region, and setting the analysis region in correspondence to the reaction region selected.

Similarly, the failure analysis program is preferably configured as follows; the analysis region setting process comprises comparing an area of the reaction region extracted, with a predetermined area threshold to select the reaction region used in the setting of the analysis region, and setting the analysis region in correspondence to the reaction region selected.

When the reaction region used in the setting of the analysis region is extracted and selected by applying the area threshold in addition to the intensity threshold to the failure observed image as described above, it becomes feasible to set the analysis region after a region unnecessary for the failure analysis is eliminated out of extracted reaction regions. This improves the certainty of the failure analysis of the semiconductor device using the failure observed image.

The failure analysis apparatus is preferably configured as follows; the failure analyzing means has net information analyzing means for analyzing a plurality of nets included in a layout of the semiconductor device, with reference to the layout information, to extract a net passing the analysis region.

Similarly, the failure analysis method is preferably configured as follows; the failure analyzing step comprises a net information analyzing step of analyzing a plurality of nets included in a layout of the semiconductor device, with reference to the layout information, to extract a net passing the analysis region.

Similarly, the failure analysis program is preferably configured as follows; the failure analyzing process comprises a net information analyzing process of analyzing a plurality of nets included in a layout of the semiconductor device, with reference to the layout information, to extract a net passing the analysis region.

In the above configuration, the analysis of the failure of the semiconductor device is carried out by extracting a net passing the analysis region out of the nets constituting the semiconductor device, with reference to the analysis region set corresponding to the reaction information in the failure observed image. This configuration makes it feasible to estimate a net with a high possibility of a failure in the semiconductor device by the net passing the analysis region.

The failure analysis apparatus is preferably configured as follows; the analysis region setting means sets the analysis region in a layout coordinate system corresponding to a layout of the semiconductor device. Similarly, the failure analysis method is preferably configured as follows; the analysis region setting step comprises setting the analysis region in a layout coordinate system corresponding to a layout of the semiconductor device. Similarly, the failure analysis program is preferably configured as follows; the analysis region setting process comprises setting the analysis region in a layout coordinate system corresponding to a layout of the semiconductor device.

When the analysis region extracted and set from the failure observed image is expressed in the layout coordinate system instead of the coordinate system on the image as described above, the scope of application of the analysis region can be expanded. This makes it feasible to increase degrees of freedom for specific analysis methods in the failure analysis of the semiconductor device using the analysis region.

The failure analysis apparatus is preferably configured as follows; the failure analyzing means has mask region setting means for, using a standard observed image being an observed image containing reaction information of a standard semiconductor device, comparing an intensity distribution in the standard observed image with the predetermined intensity threshold to extract a standard reaction region, and for setting a mask region in correspondence to the standard reaction region; and the analysis region setting means performs the extraction of the reaction region and the setting of the analysis region, using the failure observed image masked with the mask region.

Similarly, the failure analysis method is preferably configured as follows; the failure analyzing step comprises a mask region setting step of, using a standard observed image being an observed image containing reaction information of a standard semiconductor device, comparing an intensity distribution in the standard observed image with the predetermined intensity threshold to extract a standard reaction region, and setting a mask region in correspondence to the standard reaction region; and the analysis region setting step comprises performing the extraction of the reaction region and the setting of the analysis region, using the failure observed image masked with the mask region.

Similarly, the failure analysis program is preferably configured as follows; the failure analyzing process comprises a mask region setting process of, using a standard observed image being an observed image containing reaction information of a standard semiconductor device, comparing an intensity distribution in the standard observed image with the predetermined intensity threshold to extract a standard reaction region, and setting a mask region in correspondence to the standard reaction region; and the analysis region setting process comprises performing the extraction of the reaction region and the setting of the analysis region, using the failure observed image masked with the mask region.

When the mask region is set corresponding to the standard reaction region arising from nondefective emission or the like, using the standard observed image acquired from an object of a standard semiconductor device, for example, a nondefective semiconductor device as described above, the analysis region can be set after a region not arising from a failure is eliminated out of reaction regions extracted from the failure observed image. This improves the certainty of the failure analysis of the semiconductor device using the failure observed image.

The failure analysis apparatus is preferably configured as follows; the failure analyzing means has analysis object selecting means for selecting a layer as an object for the failure analysis, for a layer structure of the semiconductor device. Similarly, the failure analysis method is preferably configured as follows; the failure analyzing step comprises an analysis object selecting step of selecting a layer as an object for the failure analysis, for a layer structure of the semiconductor device. Similarly, the failure analysis program is preferably configured as follows; the failure analyzing process comprises an analysis object selecting process of selecting a layer as an object for the failure analysis, for a layer structure of the semiconductor device.

This configuration permits us to select and limit a layer as an object for the failure analysis according to need, with reference to a specific acquisition method of the failure observed image or the like. This improves the certainty of the failure analysis of the semiconductor device using the failure observed image.

The failure analysis apparatus is preferably configured as follows; the analysis region setting means sets the analysis region in a state in which a blank space of a predetermined width is added to a periphery of the reaction region. Similarly, the failure analysis method is preferably configured as follows; the analysis region setting step comprises setting the analysis region in a state in which a blank space of a predetermined width is added to a periphery of the reaction region.

### Industrial Applicability

The present invention is applicable as the semiconductor failure analysis apparatus, failure analysis method, and failure analysis program capable of securely and efficiently performing the analysis of the failure of the semiconductor device using the failure observed image.

## Claims

1. A semiconductor failure analysis apparatus for analyzing a failure of a semiconductor device, comprising:
inspection information acquiring means for acquiring a failure observed image containing reaction information arising from a failure, acquired by conducting an inspection about the failure, as an observed image of the semiconductor device; and
failure analyzing means for analyzing the failure of the semiconductor device with reference to the failure observed image and layout information of the semiconductor device;
wherein the failure analyzing means has analysis region setting means for comparing an intensity distribution in the failure observed image with a predetermined intensity threshold to extract a reaction region as the reaction information, and for setting an analysis region used in the analysis of the failure of the semiconductor device, in correspondence to the reaction region.

2. The failure analysis apparatus according to claim 1, wherein the analysis region setting means compares an area of the reaction region extracted, with a predetermined area threshold to select the reaction region used in the setting of the analysis region, and sets the analysis region in correspondence to the reaction region selected.

3. The failure analysis apparatus according to claim 1 or 2, wherein the failure analyzing means has net information analyzing means for analyzing a plurality of nets included in a layout of the semiconductor device, with reference to the layout information, to extract a net passing the analysis region.

4. The failure analysis apparatus according to any one of claims 1 to 3, wherein the analysis region setting means sets the analysis region in a layout coordinate system corresponding to a layout of the semiconductor device.

5. The failure analysis apparatus according to any one of claims 1 to 4,
wherein the failure analyzing means has mask region setting means for, using a standard observed image being an observed image containing reaction information of a standard semiconductor device, comparing an intensity distribution in the standard observed image with the predetermined intensity threshold to extract a standard reaction region, and for setting a mask region in correspondence to the standard reaction region, and
wherein the analysis region setting means performs the extraction of the reaction region and the setting of the analysis region, using the failure observed image masked with the mask region.

6. The failure analysis apparatus according to any one of claims 1 to 5, wherein the failure analyzing means has analysis object selecting means for selecting a layer as an object for the failure analysis, for a layer structure of the semiconductor device.

7. The failure analysis apparatus according to any one of claims 1 to 6, wherein the analysis region setting means sets the analysis region in a state in which a blank space of a predetermined width is added to a periphery of the reaction region.

8. A semiconductor failure analysis method of analyzing a failure of a semiconductor device, comprising:
an inspection information acquiring step of acquiring a failure observed image containing reaction information arising from a failure, acquired by conducting an inspection about the failure, as an observed image of the semiconductor device; and
a failure analyzing step of analyzing the failure of the semiconductor device with reference to the failure observed image and layout information of the semiconductor device;
wherein the failure analyzing step comprises an analysis region setting step of comparing an intensity distribution in the failure observed image with a predetermined intensity threshold to extract a reaction region as the reaction information, and setting an analysis region used in the analysis of the failure of the semiconductor device, in correspondence to the reaction region.

9. The failure analysis method according to claim 8, wherein the analysis region setting step comprises comparing an area of the reaction region extracted, with a predetermined area threshold to select the reaction region used in the setting of the analysis region, and setting the analysis region in correspondence to the reaction region selected.

10. The failure analysis method according to claim 8 or 9, wherein the failure analyzing step comprises a net information analyzing step of analyzing a plurality of nets included in a layout of the semiconductor device, with reference to the layout information, to extract a net passing the analysis region.

11. The failure analysis method according to any one of claims 8 to 10, wherein the analysis region setting step comprises setting the analysis region in a layout coordinate system corresponding to a layout of the semiconductor device.

12. The failure analysis method according to any one of claims 8 to 11,
wherein the failure analyzing step comprises a mask region setting step of, using a standard observed image being an observed image containing reaction information of a standard semiconductor device, comparing an intensity distribution in the standard observed image with the predetermined intensity threshold to extract a standard reaction region, and setting a mask region in correspondence to the standard reaction region, and
wherein the analysis region setting step comprises performing the extraction of the reaction region and the setting of the analysis region, using the failure observed image masked with the mask region.

13. The failure analysis method according to any one of claims 8 to 12, wherein the failure analyzing step comprises an analysis object selecting step of selecting a layer as an object for the failure analysis, for a layer structure of the semiconductor device.

14. The failure analysis method according to any one of claims 8 to 13, wherein the analysis region setting step comprises setting the analysis region in a state in which a blank space of a predetermined width is added to a periphery of the reaction region.

15. A program for letting a computer execute a semiconductor failure analysis of analyzing a failure of a semiconductor device,
the program letting the computer execute:
an inspection information acquiring process of acquiring a failure observed image containing reaction information arising from a failure, acquired by conducting an inspection about the failure, as an observed image of the semiconductor device; and
a failure analyzing process of analyzing the failure of the semiconductor device with reference to the failure observed image and layout information of the semiconductor device;
wherein the failure analyzing process comprises an analysis region setting process of comparing an intensity distribution in the failure observed image with a predetermined intensity threshold to extract a reaction region as the reaction information, and setting an analysis region used in the analysis of the failure of the semiconductor device, in correspondence to the reaction region.

16. The failure analysis program according to claim 15, wherein the analysis region setting process comprises comparing an area of the reaction region extracted, with a predetermined area threshold to select the reaction region used in the setting of the analysis region, and setting the analysis region in correspondence to the reaction region selected.

17. The failure analysis program according to claim 15 or 16, wherein the failure analyzing process comprises a net information analyzing process of analyzing a plurality of nets included in a layout of the semiconductor device, with reference to the layout information, to extract a net passing the analysis region.

18. The failure analysis program according to any one of claims 15 to 17, wherein the analysis region setting process comprises setting the analysis region in a layout coordinate system corresponding to a layout of the semiconductor device.

19. The failure analysis program according to any one of claims 15 to 18,
wherein the failure analyzing process comprises a mask region setting process of, using a standard observed image being an observed image containing reaction information of a standard semiconductor device, comparing an intensity distribution in the standard observed image with the predetermined intensity threshold to extract a standard reaction region, and setting a mask region in correspondence to the standard reaction region, and
wherein the analysis region setting process comprises performing the extraction of the reaction region and the setting of the analysis region, using the failure observed image masked with the mask region.

20. The failure analysis program according to any one of claims 15 to 19, wherein the failure analyzing process comprises an analysis object selecting process of selecting a layer as an object for the failure analysis, for a layer structure of the semiconductor device.
